# EUROPEAN PATENT SPECIFICATION

(11) **EP 0 994 513 B1**
(45) Date of publication and mention of the grant of the patent: **25.02.2004**
(21) Application number: 98830614.8
(22) Date of filing: 15.10.1998
(51) Int. Cl.: H01L 27/115, H01L 21/8247, H01L 29/788

(54) **A simplified process for defining the tunnel area in semiconductor non-volatile non-aligned memory cells**
Vereinfachtes Verfahren zur Bestimmung des Tunnelgebiets in nichtflüchtigen, nicht selbstjustierten Halbleiterspeicherzellen
Procédé simplifié pour définir la zone tunnel dans des cellules mémoire non volatiles et non alignées

(43) Date of publication of application: 19.04.2000
(73) Proprietor: STMicroelectronics S.r.l., 20041 Agrate Brianza (Milano) (IT)
(72) Inventor: Patelmo, Matteo, 20044 Bernareggio (Milano) (IT); Dalla Libera, Giovanna, 20052 Monza (IT); Galbiati, Nadia, c/o STMicroelectronics S.r.l., 20041 Agrate Brianza (Milano) (IT); Vajana, Bruno, 24100 Bergamo (IT)
(74) Representative: Botti, Mario

(56) References cited:
- EP-A- 0 676 811
- EP-A- 0 782 196
- US-A- 5 066 992
- US-A- 5 793 081

## Description

### Field of application

The present invention relates to a simplified process for the definition of the area of tunnel in non-volatile semiconductor non-self-aligning memory cells.

In particular, the invention relates to a process of the above mentioned type for the production of non-volatile semiconductor floating gate non-self-aligned memory cells, which are incorporated in a matrix of cells with associated control circuitry, to each cell a selection transistor being associated, the process comprising at least the following phases:
- growth or deposition of a layer of gate dielectric of the sensing transistor and of the cell;
- tunnel mask for defining the area of tunnel;
- cleaning etching of the gate dielectric layer in the tunnel area reaching the surface of the semi-conductor;
- growth of the tunnel oxide.

The invention relates in particular, but not exclusively, to the production of EEPROM FLOTOX memory cells and the following description is made with reference to this field of application with the sole objective of simplifying its exposition.

### Prior art

It is well known that EEPROM type memory cells are formed by a field effect transistor equipped with a floating gate capacitively coupled to a control gate terminal. Such floating gate transistor is connected in series to a selection transistor.

The floating port is formed by a first layer of polysilicon, so-called polyl; while the control gate is formed by an overlaying second layer of polysilicon, so called poly2.

While in the memory cells the layers of polyl and poly2 are separated by an intermediate dielectric layer of interpoly dielectric, the selection transistor gate is formed by only one layer of poly. A process for manufacturing such a memory cell is known as non-DPCC process.

Processes for forming such EEPROM cells are described in EP-A-0 676 811 and US-A-5 066 992.

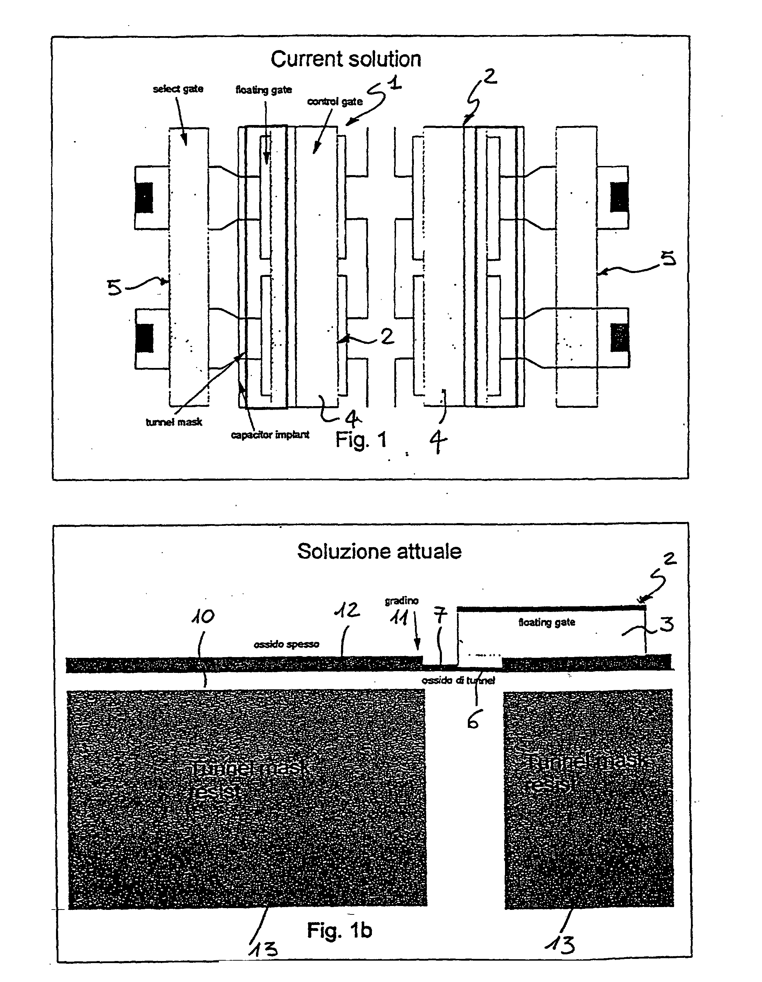

Figure 1 schematically shows from above and in enlarged scale a portion of semiconductor substrate 10 taken up by a single memory cell 1 EEPROM of known type comprising a field effect transistor 2 equipped with a floating gate 3 capacitively coupled to a control gate terminal 4. Such floating gate transistor 2 is connected in series to a selection transistor 5.

The floating gate 3, in which the charges are stored, is formed by the first layer of polyl, while the gate control 4 is formed by the second layer of poly2.

A thin layer of tunnel oxide 6, having a thickness of about 80 Angstroms (10 Angstroms = 1nm), is provided between the floating gate 3 and the semiconductor substrate 10. Electrical charges pass via such tunnel oxide 9 due to the Fowler-Nordheim effect, during the memory cell 1 programming phase.

A diffused area formed in the substrate 10 and partially below the gate region, is destined for a capacitor implant which helps to form a pocket of electrons which allows for an efficient injection by the Fowler-Nordheim tunnel effect.

In the new generation technology the tunnel area 6 is defined by means of a stripe which is situated in part under the floating gate 3, and which represents the actual tunnel area 6, and partly on the outside in the direction of the selection transistor 5. The portion extending outside the floating gate is indicated with 7 in Figure 1b.

This arrangement is foreseen for reducing the lithographic and tunnel area etching criticalness, as shown in Figures 1 and 1b.

A similar process is described in US-A-5 066 992.

The process steps for defining such a tunnel area are the following
- growth of a thick oxide layer 12;
- masking of the tunnel area by means of a layer of resist 13;
- etching of the thick oxide in the tunnel area
- removal of resist 13
- growth of tunnel oxide.

This known solution presents a problem due to a step 11 which is created in the layer of thick oxide 12 between the selection transistor 5 and the floating gate 3. Such step 11 notably complicates the removal of the thick layer of oxide 12 necessary for following phases of the non-DPCC non-self-aligned process for the production of EEPROM memories. Typically after the definition of the floating gate, that is of the layer of polyl, the thick oxide 12 is etched to make then the gate oxides of the circuitry associated with the cell matrix regrown. This etching of thick oxide 12 must reach the surface of the semi-conductor 10 without damaging it.

Nevertheless, in the presence of disuniformities of the oxide itself, such as those due to the step 11, the etching phase can be noxious because there is the risk of overetching the thick oxide 12 in some areas in order to be able to remove it completely in others.

The technical problem at the basis of the present invention is that of finding a non-DPCC and non-self-aligned process flow of a simplified type having characteristics such as to permit the production of semiconductor FLOTOX EEPROM type memory cells having a uniform layer of oxide on all the active areas even after the growth of the tunnel oxide.

### Summary of the Invention

The resolutive idea at the basis of the invention is that of designing the tunnel mask in such a way as to remove all the thick oxide except that in the sensing transistor area, that is to say in the portion of memory cell comprised between the capacitor implant and the source diffusion. This allows for a uniform oxide on all of the active areas which can be removed in an easier way.

On the basis of such resolutive idea the technical problem is resolved by a process of the type previously indicated and defined by claim 1 and following dependent claims.

The features and the advantages of the process according to the invention will be seen from the description, following herein, of an indicative and not limiting example of embodiment given with reference to the attached drawings.

### Brief description of the drawings

- Figure 1 shows a schematic view in enlarged scale and from above of a portion of integrated circuit on semiconductor comprising at least one pair of EEPROM memory cells of the known type produced according to a non-DPCC process each one with an associated selection transistor;
- Figure 1b shows a schematic view in enlarged scale and in vertical section of a cell of known type with a respective selection transistor
- Figure 2 shows a schematic view in enlarged scale and from above of a portion of integrated circuit on semi-conductor comprising at least one pair of EEPROM memory cells produced according to the present invention, each one with an associated selection transistor;
- Figure 2B shows a schematic view in enlarged scale and in vertical section of a cell according to the invention with respective selection transistor.

### Detailed description

The phases of the process and the structures described as follows do not form a complete process flow for the manufacture of integrated circuits. The present invention can be put into practice together with the manufacturing techniques of integrated circuits actually used in the field at the momento. Only the commonly used phases of the process which are necessary for the comprehension of the present invention are included.

The Figures representing cross sections of portions of an integrated circuit during its manufacturing are not drawn to scale, but are designed in such a way as to illustrate the important features of the invention.

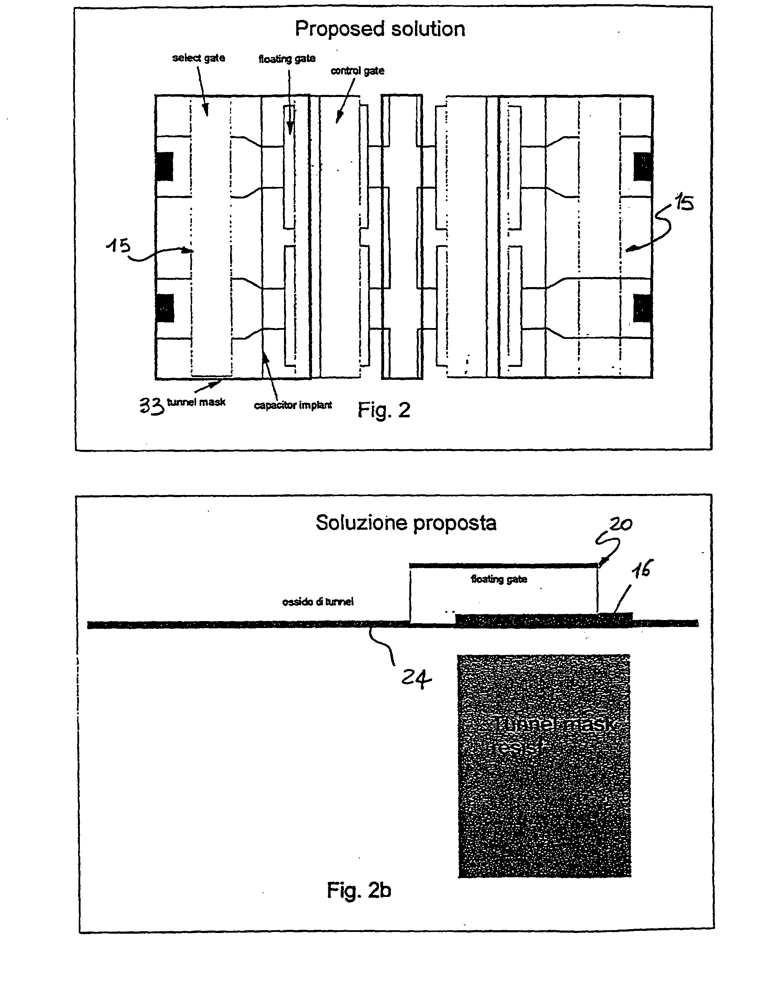

With particular reference to the examples in Figures 2 and 2b, we analyse hereinbelow the process steps according to the invention which lead us to the production of non-self-aligned EEPROM memory cells 20.

A cell 20 according to the invention, with a respective selection transistor 15, is obtained by means of a CMOS process of the non-DPCC and non-self-aligned type in which, starting from a P type substrate, the following initial steps are carried out:
- masking for the capacitor implant with respective implant;
- growth or deposition of a dielectric layer 16 which will form the gate dielectric of the sensing transistor and of the cell 20;
- tunnel mask 33 to define the tunnel area;
- cleaning etching of the gate dielectric layer 16 in the tunnel area reaching the surface of the semi-conductor;
- growth of the tunnel oxide 24.

Advantageously, according to the invention, the tunnel mask 33 is designed in a different way with respect to the prior art.

In particular, the tunnel mask 33 according to the invention is extended above the region occupied by the selection transistor 15 in such a way as to allow for the removal of all the thick oxide 16 except for that which is in the region of the sensing transistor, that is to say, in the portion of memory cell comprised between the capacitor implant and the source diffusion.

This allows for a uniform layer of oxide on all the active areas. Such layer of oxide can be removed in a very simple way.

Essentially, the process steps for defining the tunnel area are the same as those by the prior art, Nevertheless, during the step of the removal of the thick oxide 16 phase, such oxide is removed from everywhere except in the area of the sensing transistors of the EEPROM cells.

The solution according to the invention means that, after the growth of the tunnel oxide, a uniform oxide on all active areas can be obtained, though excluding the active areas of the sensing transistors. This uniformity is essential for a correct removal of the oxide which occurs in subsequent steps of the process, typically before the growth of the oxides of the control circuitry.

The active area of the control circuitry undergoes one additional oxide etch with respect to the usual technique. This disadvantage, though, is mitigated by the fact that such etching can be exactly calibrated on the uniform thick layer in order not to excessively damage the active area itself.

The modification to the tunnel mask proposed by the present invention does not worsen possible problems of disalignment between the masks with respect to the solutions of the prior art.

The possible presence of a residual step in the portion of semi-conductor comprised between two cells 20 does not create problems of any sort.

## Claims

1. A simplified non-DPCC process of manufacturing non-volatile memory cells integrated on a semiconductor substrate and incorporated in a cell matrix with associated control circuitry, each cell having a non-aligned floating gate and a respective selection transistor (15), the process comprising at least the following steps:
- growth or deposition of a dielectric layer (16) on the surface of the semiconductor substrate;
- forming a tunnel mask (33) on said dielectric layer (16) for defining the tunnel area;
- cleaning etching said dielectric layer (16) in the tunnel area reaching the surface of the semiconductor substrate;
- growth of a tunnel oxide layer (24);
**characterised in that** said tunnel area defined by said tunnel mask extends from a portion of the floating gate adjacent to the selection transistor to and including the region occupied by the selection transistor.

2. Process according to claim 1, wherein each cell comprises a capacitor implant region and a source diffusion, **characterised in that** said mask covers the memory cell between the capacitor implant region and the source diffusion.

3. Process according to claim 1, **characterised in that** after said growth of tunnel oxide one uniform layer of oxide is present on all active areas of the memory cell matrix.

## Patentansprüche

1. Ein vereinfachtes nicht-DPCC Verfahren zum Herstellen von auf einem Halbleitersubstrat integrierten und in einer Zellmatrix mit zugehörigen Steuerschaltkreisen enthaltenen nichtflüchtigen Speicherzellen, wobei jede Zelle ein nichtjustiertes schwebendes Gate und einen entsprechenden Auswahltransistor (15) aufweist, wobei der Prozess mindestens die folgenden Schritte umfasst:
- Aufwachsen oder Abscheiden einer dielektrischen Schicht (16) auf der Oberfläche des Halbleitersubstrats;
- Erzeugen einer Tunnelmaske (33) auf der dielektrischen Schicht (16) zum Festlegen des Tunnelbereichs;
- Reinigungs-Ätzen der dielektrischen Schicht (16) im Tunnelbereich, wobei die Oberfläche des Halbleitersubstrats erreicht wird;
- Aufwachsen einer Tunneloxidschicht (24);
**dadurch gekennzeichnet, dass** sich der durch die Tunnelmaske festgelegte Tunnelbereich von einem Teil des schwebenden Gate neben dem Auswahltransistor bis zu und einschließlich dem vom Auswahltransistor belegten Bereich erstreckt.

2. Verfahren entsprechend Anspruch 1, wobei jede Zelle einen Kondensator-Implantationsbereich und eine Sourcediffusion aufweist, **dadurch gekennzeichnet, dass** die Maske die Speicherzelle zwischen dem Kondensator-Implantationsbereich und der Sourcediffusion abdeckt.

3. Verfahren entsprechend Anspruch 1, **dadurch gekennzeichnet, dass** nach dem Aufwachsen von Tunneloxid eine gleichmäßige Oxidschicht auf allen aktiven Bereichen der Speicherzelle vorhanden ist.

## Revendications

1. Un processus non-DPCC simplifié de fabrication de cellules mémoire non volatiles intégrées sur un substrat semiconducteur et incorporées dans une matrice de cellules avec des circuits de commande associés, chaque cellule possédant une grille flottante non alignée et un transistor de sélection (15) respectif, le processus comprenant au moins les étapes suivantes:
- croissance ou dépôt d'une couche diélectrique (16) en surface du substrat semiconducteur ;
- formation d'un masque de tunnel (33) sur ladite couche diélectrique (16) pour définition de la région de tunnel ;
- gravure nettoyage de ladite couche diélectrique (16) dans la région de tunnel en atteignant la surface du substrat semiconducteur ;
- croissance d'une couche d'oxyde de tunnel (24) ;
**caractérisé en ce que** ladite région de tunnel définie par ledit masque de tunnel s'étend depuis une partie de la grille flottante adjacente au transistor de sélection jusqu'à, et y compris, la région occupée par le transistor de sélection.

2. Processus selon la revendication 1 dans lequel chaque cellule comprend une région d'implant de condensateur et une diffusion de source, **caractérisé en ce que** ledit masque recouvre la cellule mémoire entre la région d'implant de condensateur et la diffusion de source.

3. Processus selon la revendication 1, **caractérisé en ce qu'**après ladite croissance d'oxyde de tunnel une couche uniforme d'oxyde est présente sur toutes les régions actives de la matrice de cellules mémoire.
